# EUROPEAN PATENT APPLICATION

(11) **EP 4 693 000 A1**
(43) Date of publication of application: **11.02.2026**
(21) Application number: 24858195.1
(22) Date of filing: 30.07.2024
(51) Int. Cl.: G06F 3/041

(54) **DISPLAY TOUCH MODULE AND ELECTRONIC DEVICE**

(30) Priority: 31.08.2023 CN 202311138335
(71) Applicant: Huawei Technologies Co., Ltd., Shenzhen, Guangdong 518129 (CN)
(72) Inventor: LIU, Guohe, Shenzhen, Guangdong 518129 (CN); CHEN, Zesheng, Shenzhen, Guangdong 518129 (CN); ZHANG, Junyong, Shenzhen, Guangdong 518129 (CN); HE, Hu, Shenzhen, Guangdong 518129 (CN)
(74) Representative: Huawei European IPR
(86) International application number: PCT/CN2024/108451
(87) International publication number: WO 2025/044652

(57) **Abstract**

This application discloses a display touch module and an electronic device. The display touch module includes a display panel, a first organic layer disposed on the display panel, and a second organic layer disposed on the first organic layer. The display touch module further includes a first metal layer and a second metal layer. The first metal layer is disposed in the first organic layer, and the second metal layer is disposed in the second organic layer. In comparison with using an inorganic layer, the display touch module has a better deformation capability. The first metal layer includes first electrodes, the second metal layer includes second electrodes, and the first electrodes and the second electrodes are configured to output a first signal when a touch operation is detected. No via is required for bridging, to reduce a risk of signal disconnection caused by a via residue. Projections of the first electrodes on the second metal layer and the second electrodes are alternately arranged in a first direction and a second direction respectively, the first direction is perpendicular to the second direction, and the arrangement is in a checkerboard manner, to reduce a drive load of a touch control module.

## Description

This application claims priority to Chinese Patent Application No. 202311138335.5, filed with the China National Intellectual Property Administration on August 31, 2023 and entitled "DISPLAY TOUCH MODULE AND ELECTRONIC DEVICE", which is incorporated herein by reference in its entirety.

### TECHNICAL FIELD

Embodiments of this application relate to the display field, and in particular, to a display touch module and an electronic device.

### BACKGROUND

Currently, flexible display panels are widely used in foldable electronic devices. However, the foldable electronic devices usually have a folding reliability problem. In a bending process of the foldable electronic device, film layers generate stress and deformation of different degrees when being subject to a force, and as a bending radius decreases, the stress and the deformation generated by the film layers increase. If stress or deformation of a film layer in the bending process exceeds a failure threshold of the film layer, the film layer generates a crack (crack) and even peeling (peeling). As a result, a folding function fails, causing serious display defects such as a black spot and a black screen.

In addition, flexible display panels such as double-curved display panels and quad-curved display panels may also be used in bar-type phones. These new forms usually need to be used with 3D covers. For example, when a display panel body has a poor deformation resistance capability and is attached to the cover, a crack is likely to be generated at a position like a curved edge or a rounded corner. Finally, a black spot or a black screen is generated due to an encapsulation failure of the display panel.

An organic touch on encapsulation (Touch on Encapsulation, TOE) technology can improve a bending deformation capability of the display panel body. However, a new organic material has high fluidity. Consequently, a yield rate of organic touch on encapsulation is greatly reduced compared with that of inorganic touch on encapsulation.

### SUMMARY

Embodiments of this application provide a display touch module and an electronic device, so that a bending deformation capability is improved while a yield rate of organic upper touch integration can be ensured.

According to a first aspect of embodiments of this application, a display touch module is provided, including a display panel and an organic layer disposed on the display panel, where the organic layer includes a first organic layer and a second organic layer. The display touch module further includes a first metal layer and a second metal layer, the first metal layer is disposed in the first organic layer, and the second metal layer is disposed in the second organic layer. The first metal layer includes first electrodes, the second metal layer includes second electrodes, and the first electrodes and the second electrodes are configured to output a first signal when a touch operation is detected. Projections of the first electrodes on the second metal layer and the second electrodes are alternately arranged in a first direction and a second direction respectively, and the first direction is perpendicular to the second direction. In this way, the organic layer, the first metal layer, and the second metal layer form a touch integration layer. The organic layer is configured to encapsulate the first metal layer and the second metal layer. In comparison with using an inorganic encapsulation layer, the display touch module has a better deformation capability, thereby reducing a break risk of the display touch module in a large strain or deformation process. In addition, the first electrodes and the second electrodes are disposed at different layers. In comparison with disposing the first electrodes and the second electrodes at a same layer, there is no need to use a design with a large quantity of micro vias for bridging in the organic layer, to avoid a via residue caused by insufficient resolution of an organic material, so as to reduce a risk of signal disconnection caused by the via residue, and improve a product yield rate. In addition, projections of the first electrodes on the second metal layer and the second electrodes are mutually nested, and an arrangement is in a checkerboard manner, to reduce a drive load of a touch control module.

In an optional implementation, sizes of each first electrode in the first direction and the second direction remain unchanged, and sizes of each second electrode in the first direction and the second direction remain unchanged. In this way, sizes of a single electrode in the first direction and the second direction remain unchanged, so that when a stylus slides over a screen, signal strength at all positions are even, performance of the active stylus is better, and linearity effect is better.

In an optional implementation, both the first electrode and the second electrode use a square pattern. In this way, sizes of a single electrode in the first direction and the second direction can be even and unchanged, so that when the stylus slides over the screen, the signal strength at all the positions are even, the performance of the active stylus is better, and the linearity effect is better.

In an optional implementation, the display panel includes a plurality of pixel regions arranged in an array, the first electrode includes a plurality of first sub-metal conducting wires, and the plurality of first sub-metal conducting wires form a plurality of metal grids; the second electrode includes a plurality of second sub-metal conducting wires, and the plurality of second sub-metal conducting wires form a plurality of metal grids. The plurality of metal grids correspond to the plurality of pixel regions. In this way, both the first electrode and the second electrode use a metal grid structure, so that the metal grid can be disposed directly facing and surrounding the pixel region, to effectively prevent display brightness of the pixel region from being affected when the metal conducting wire is overlapped with the pixel region.

In an optional implementation, the plurality of first electrodes extend in a third direction, and the plurality of second electrodes extend in a fourth direction, where the third direction intersects with the fourth direction, an overlapping width of a cross position of the first electrode and the second electrode is greater than or equal to a line width of the metal grid, and an overlapping width of a non-cross position of the first electrode and the second electrode is less than the line width of the metal grid. In this way, the overlapping width of the first electrode and the second electrode is only at a line width level, and the overlapping width of the first electrode and the second electrode is reduced, so that induction capacitance of the first sub-metal conducting wires and the second sub-metal conducting wires in a vertical stacking direction can be effectively reduced, to further reduce the drive load of the touch control module.

In an optional implementation, the line width of the metal grid is 3 µm to 6 µm. In this way, the line width of the metal grid is at a micron level, and the overlapping width of the first electrode and the second electrode is reduced, so that the induction capacitance of the first sub-metal conducting wires and the second sub-metal conducting wires in the vertical stacking direction can be effectively reduced, to further reduce the drive load of the touch control module.

In an optional implementation, the first metal layer further includes a plurality of first floating metal grids, the floating metal grids are disposed between adjacent first electrodes and spaced from each other, and the first floating metal grids are insulated from the first electrodes. In this way, the first floating metal grid reduces a large-area overetched region of the organic layer at gap positions between the first electrodes, and reduces flow of the organic layer above the first metal layer to the gaps between the first electrodes. In this way, loss of the organic layer between the first metal layer and the second metal layer is reduced, and a risk of a short circuit between the first metal layer and the second metal layer is reduced.

In an optional implementation, the second metal layer further includes a plurality of second floating metal grids, the second floating metal grids are disposed between adjacent second electrodes and spaced from each other, and the floating metal grids are insulated from the second electrodes. In this way, the second floating metal grid improves flatness of an upper part of the second metal layer.

In an optional implementation, projections of the plurality of first floating metal grids on the second metal layer all coincide with the second metal grids. In this way, the floating metal grids are disposed in all gaps of the first metal layer, so that the second organic layer can be further prevented from flowing to the gap positions.

In an optional implementation, projections of the plurality of first floating metal grids on the second metal layer partially coincide with the second metal grids. In this way, the floating metal grids are disposed in a part of gaps of the first metal layer, so that a load of the first metal layer can be reduced, and touch performance can be improved.

In an optional implementation, projections of the plurality of second floating metal grids on the first metal layer all coincide with the first metal grids. In this way, the floating metal grids are disposed in all gaps of the second metal layer, so that flatness of the upper part of the second metal layer can be further improved.

In an optional implementation, projections of the plurality of second floating metal grids on the first metal layer partially coincide with the first metal grids. In this way, the floating metal grids are disposed in a part of gaps of the second metal layer, so that a load of the first metal layer can be reduced, and touch performance can be improved.

In an optional implementation, the display touch module further includes a bent part and a lower bonding region, one end of the display panel is connected to the lower bonding region through the bent part, the lower bonding region is bent to a back side of a light outlet surface of the display panel through the bent part, the lower bonding region includes a first metal trace, the first metal trace is electrically connected to the first metal layer and the second metal layer, and a connection point between the metal trace and the first metal layer and a connection point between the metal trace and the second metal layer are located outside the lower bonding region. In this way, the first metal trace in the lower bonding region is used to replace traces of the first metal layer and the second metal layer, and a touch integrated metal trace and the first organic layer or the second organic layer may be removed from the lower bonding region, to avoid an etching residue of the first metal layer or the second metal layer on the first organic layer or the second organic layer, and reduce a risk of touch signal disconnection.

In an optional implementation, the display panel includes an active area, a non-active area, and an organic clearance region and a dam that are located in the non-active area, where the organic clearance region and the dam are spaced from each other, both the organic clearance region and the dam are disposed around the active area, and in a region in which the non-active area is adjacent to the bent part, a single-layer trace is used for the first metal layer and the second metal layer above the organic clearance region and the dam. In this way, the single-layer metal trace is disposed above the organic clearance region and the dam, to reduce etching metal residues of the first metal layer and the second metal layer above the dam and the organic clearance region in the region in which the non-active area is adjacent to the bent part, and reduce the risk of the short circuit.

In an optional implementation, the organic clearance region includes a first organic clearance region, a second organic clearance region, and a third organic clearance region that are successively disposed in a direction away from the bent part, and the dam includes a first dam and a second dam, where the first dam is located between the first organic clearance region and the second organic clearance region, the second dam is located between the second organic clearance region and the third organic clearance region, and a height of the first dam is greater than a height of the second dam. In this way, a double-layer dam is disposed, to better limit the organic layer in a region of the display panel.

In an optional implementation, the organic layer includes the first organic layer, the second organic layer, and a third organic layer that are stacked in a direction away from the display panel, where the first metal layer is disposed on a surface that is of the first organic layer and that is close to the second organic layer, the second organic layer covers the first metal layer, the second metal layer is disposed on a surface that is of the second organic layer and that is close to the third organic layer, and the third organic layer covers the second metal layer. In this way, a three-layer organic layer is disposed, so that the first metal layer and the second metal layer can be wrapped in the organic layer, and packaging effect is better.

In an optional implementation, the display touch module further includes an encapsulation layer, and the encapsulation layer is located between the display panel and the organic layer. In this way, the display touch module uses an organic touch on encapsulation structure.

According to a second aspect of embodiments of this application, a display touch module is provided, including a display panel, a bent part, a lower bonding region, a first organic layer, a second organic layer, a first metal layer, and a second metal layer, where one end of the display panel is connected to the lower bonding region through the bent part, the lower bonding region is bent to a back side of a light outlet surface of the display panel through the bent part, the first organic layer is disposed on the display panel, the second organic layer is disposed on the first organic layer, the first metal layer is disposed in the first organic layer, the second metal layer is disposed in the second organic layer, the first metal layer includes first electrodes, the second metal layer includes second electrodes, the first electrodes and the second electrodes are configured to output a first signal when a touch operation is detected, the lower bonding region includes a first metal trace, the first metal trace is electrically connected to the first metal layer and the second metal layer, and a connection point between the metal trace and the first metal layer and a connection point between the metal trace and the second metal layer are located outside the lower bonding region.

According to a third aspect of embodiments of this application, a display touch module is provided, including a display panel, a bent part, a lower bonding region, a first organic layer, a second organic layer, a first metal layer, and a second metal layer, where one end of the display panel is connected to the lower bonding region through the bent part, the lower bonding region is bent to a back side of a light outlet surface of the display panel through the bent part, the first organic layer is disposed on the display panel, the second organic layer is disposed on the first organic layer, the first metal layer is disposed in the first organic layer, the second metal layer is disposed in the second organic layer, the first metal layer includes first electrodes, the second metal layer includes second electrodes, and the first electrodes and the second electrodes are configured to output a first signal when a touch operation is detected. The display panel includes an active area, a non-active area, and an organic clearance region and a dam that are located in the non-active area, where the organic clearance region and the dam are spaced from each other, both the organic clearance region and the dam are disposed around the active area, and in a region in which the non-active area is adjacent to the bent part, a single-layer trace is used for the first metal layer and the second metal layer above the organic clearance region and the dam.

In an optional implementation, the organic clearance region includes a first organic clearance region, a second organic clearance region, and a third organic clearance region that are successively disposed in a direction away from the bent part, and the dam includes a first dam and a second dam, where the first dam is located between the first organic clearance region and the second organic clearance region, and the second dam is located between the second organic clearance region and the third organic clearance region.

According to a fourth aspect of embodiments of this application, a display touch module is provided, including a display panel, a first organic layer disposed on the display panel, and a second organic layer disposed on the first organic layer. The display touch module further includes a first metal layer and a second metal layer, the first metal layer is disposed in the first organic layer, the second metal layer is disposed in the second organic layer, the first metal layer includes first electrodes, the second metal layer includes second electrodes, the first electrodes and the second electrodes are configured to output a first signal when a touch operation is detected, and the first metal layer further includes a plurality of first floating metal grids, the first floating metal grids are disposed between adjacent first electrodes and spaced from each other, and the first floating metal grids are insulated from the first electrodes, and/or the second metal layer further includes a plurality of second floating metal grids, the second floating metal grids are disposed between adjacent second electrodes and spaced from each other, and the floating metal grids are insulated from the second electrodes.

In an optional implementation, projections of the plurality of first floating metal grids on the second metal layer coincides with the second metal grids; and/or projections of the plurality of second floating metal grids on the first metal layer coincides with the first metal grids.

According to a fifth aspect of embodiments of this application, an electronic device is provided. The electronic device further includes a touch control module and the foregoing display touch module. The touch control module is configured to identify, based on the received first signal, a position of the touch operation received by the display touch module.

Embodiments of this application provide a display touch module and an electronic device. The display touch module includes a display panel, a first organic layer disposed on the display panel, and a second organic layer disposed on the first organic layer. The display touch module further includes a first metal layer and a second metal layer, the first metal layer is disposed in the first organic layer, and the second metal layer is disposed in the second organic layer. In comparison with using an inorganic encapsulation layer, the display touch module has a better deformation capability, thereby reducing a break risk of the display touch module in a large strain or deformation process. The first metal layer includes first electrodes, the second metal layer includes second electrodes, and the first electrodes and the second electrodes are configured to output a first signal when a touch operation is detected. The first electrodes and the second electrodes are disposed at different layers. In comparison with disposing the first electrodes and the second electrodes at a same layer, there is no need to use a design with a large quantity of micro vias for bridging in the organic layer, to avoid a via residue caused by insufficient resolution of an organic material, so as to reduce a risk of signal disconnection caused by the via residue, and improve a product yield rate. Projections of the first electrodes on the second metal layer and the second electrodes are alternately arranged in a first direction and a second direction respectively. The first direction is perpendicular to the second direction, so that the projections of the first electrodes on the second metal layer and the second electrodes are mutually nested, and an arrangement is in a checkerboard manner, to reduce a drive load of a touch control module.

In some embodiments, this application further provides a display touch module. Compared with the foregoing display touch module, the display touch module further includes a bent part and a lower bonding region. One end of the display panel is connected to the lower bonding region through the bent part, and the lower bonding region is bent to a back side of a light outlet surface of the display panel through the bent part. The first metal layer and the second metal layer are stacked in a direction away from the display panel, and both the first metal layer and the second metal layer are located in the organic layer. The lower bonding region includes a first metal trace, the first metal trace is electrically connected to the first metal layer and the second metal layer, and a connection point between the metal trace and the first metal layer and a connection point between the metal trace and the second metal layer are located outside the lower bonding region. In other words, the first metal trace in the lower bonding region may be used to replace traces of the first metal layer and the second metal layer, and the touch integration layer does not need to be disposed in the lower bonding region, to reduce an etching residue of the first metal layer or the second metal layer on the organic layer, and reduce a risk of touch signal disconnection.

In some embodiments, this application further provides a display touch module. A display panel of the display touch module includes an active area, a non-active area, and an organic clearance region and a dam that are located in the non-active area, where the organic clearance region and the dam are spaced from each other, both the organic clearance region and the dam are disposed around the active area, and in a region in which the non-active area is adjacent to the bent part, a single-layer trace is used for the first metal layer and the second metal layer above the organic clearance region and the dam. In this way, the single-layer metal trace is disposed above the organic clearance region and the dam, to reduce etching metal residues of the first metal layer and the second metal layer above the dam and the organic clearance region in the region in which the non-active area is adjacent to the bent part, and reduce a risk of a short circuit.

In some embodiments, this application further provides a display touch module. A first metal layer in the display touch module further includes a plurality of first floating metal grids. The first floating metal grids are disposed between adjacent first electrodes and spaced from each other, and the first floating metal grids are insulated from the first electrodes. In this way, the first floating metal grid reduces a large-area overetched region of the organic layer at gap positions between the first electrodes, and reduces flow of the organic layer above the first metal layer to the gaps between the first electrodes. In this way, loss of the organic layer between the first metal layer and the second metal layer is reduced, and a risk of a short circuit between the first metal layer and the second metal layer is reduced.

The display touch modules in the foregoing several aspects all fall within the protection scope of this application, and a sequence of the display touch modules is not limited.

### BRIEF DESCRIPTION OF DRAWINGS

FIG. 1 is a diagram of a structure of an electronic device;
FIG. 2 is a diagram of a structure of a curved-screen mobile phone;
FIG. 3 is a diagram of a structure of a flexible-screen mobile phone;
FIG. 4 is a diagram of a structure of a display module according to an embodiment of this application;
FIG. 5 is a sectional view of the display module in FIG. 4 along NN;
FIG. 6 is another sectional view of the display module in FIG. 4 along NN;
FIG. 7 is a sectional view of the display module in FIG. 4 along NN according to an embodiment of this application;
FIG. 8 is a diagram of an arrangement manner of first electrodes according to an embodiment of this application;
FIG. 9 is a diagram of an arrangement manner of second electrodes according to an embodiment of this application;
FIG. 10 is a diagram of an arrangement manner of first electrodes and second electrodes according to an embodiment of this application;
FIG. 11 is a diagram of an overlapping position of a first electrode and a second electrode according to an embodiment of this application;
FIG. 12 is a diagram of a structure of a first metal layer;
FIG. 13 is a sectional view of the first metal layer in FIG. 12 along MM;
FIG. 14 is a diagram of a spacing between the first metal layer using the structure shown in FIG. 12 and a second metal layer;
FIG. 15 is a diagram of an arrangement manner of a first metal layer according to an embodiment of this application;
FIG. 16 is a sectional view of FIG. 15 along aa;
FIG. 17 is a diagram of another arrangement manner of a first metal layer according to an embodiment of this application;
FIG. 18 is a sectional view of FIG. 17 along bb;
FIG. 19 is a diagram of an arrangement manner of a second metal layer according to an embodiment of this application;
FIG. 20 is a sectional view of FIG. 19 along cc;
FIG. 21 is a diagram of another arrangement manner of a second metal layer according to an embodiment of this application;
FIG. 22 is a sectional view of FIG. 21 along dd;
FIG. 23 is a diagram of a structure of a display touch module according to an embodiment of this application;
FIG. 24 is a diagram of a structure of a region C in FIG. 23;
FIG. 25 is a sectional view of FIG. 24 along AB;
FIG. 26 is a diagram of a structure of a region C in FIG. 23 according to an embodiment of this application;
FIG. 27 is a sectional view of FIG. 26 along CD;
FIG. 28 is a diagram of another structure of a region C in FIG. 23 according to an embodiment of this application;
FIG. 29 is a sectional view of FIG. 28 along EF; and
FIG. 30 is a diagram of a structure of a metal trace in a lower bonding region according to an embodiment of this application.

### DESCRIPTION OF EMBODIMENTS

To make the objectives, technical solutions, and advantages of this application clearer, the following further describes this application in detail with reference to the accompanying drawings.

The terms such as "first" and "second" below are merely intended for description, and shall not be understood as an indication or implication of relative importance or implicit indication of a quantity of indicated technical features. Therefore, a feature limited by "first", "second", or the like may explicitly or implicitly include one or more features. In the descriptions of this application, unless otherwise stated, "a plurality of" means two or more than two.

In addition, in this application, position terms such as "upper" and "lower" are defined relative to an illustrative position of a component in the accompanying drawings. It should be understood that these direction terms are relative concepts and are used for relative description and clarification, and may vary accordingly depending on a position change in which components are placed in the accompanying drawings.

An embodiment of this application provides an electronic device. The electronic device may be a product having a display interface, for example, a tablet computer, a mobile phone, an e-reader, a remote control, a personal computer (personal computer, PC), a notebook computer, a personal digital assistant (personal digital assistant, PDA), a vehicle-mounted device, a web television, a wearable device, or a television, or a smart display wearable product like a smart watch or a smart band. A specific form of the electronic device is not specifically limited in embodiments of this application. For ease of description, the following embodiments are described by using an example in which the electronic device is a mobile phone.

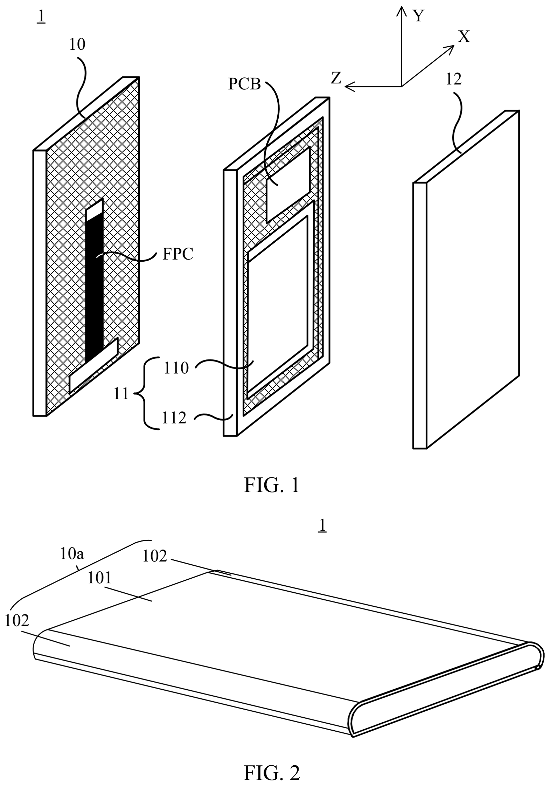

As shown in FIG. 1, an electronic device 1 includes a display module 10, a middle frame 11, and a battery cover (or referred to as a rear cover) 12. The middle frame 11 is located between the display module 10 and the battery cover 12.

The display module 10 is configured to display an image.

The display module 10, the middle frame 11, and the battery cover 12 may be separately disposed at different layers in a thickness direction of the electronic device. These layers may be parallel to each other. A plane in which each layer is located may be referred to as an X-Y plane, and a direction perpendicular to the X-Y plane may be referred to as a Z direction. In other words, the display module 10, the middle frame 11, and the battery cover 12 may be distributed hierarchically in the Z direction.

The display module 10 may be electrically connected to a PCB disposed on the middle frame 11 after a flexible printed circuit (flexible printed circuit, FPC) shown in FIG. 1 passes through the middle frame 11. Therefore, the PCB can transmit display data to the display module 10, to control the display module 10 to display an image.

The middle frame 11 is located between the display module 10 and the battery cover 12. A surface that is of the middle frame 11 and that is away from the display module 10 is used to mount internal components such as a battery, the printed circuit board (printed circuit board, PCB), a camera (camera), and an antenna. After the battery cover 12 and the middle frame 11 are covered, the internal components are located between the battery cover 12 and the middle frame 11.

The battery cover 12 is connected to the middle frame 11 to form an accommodation cavity used to accommodate the electronic components such as the PCB, the camera, and the battery. In this way, outside moisture and dust can be prevented from entering the accommodation cavity and affecting performance of the electronic components.

A structure of the mobile phone is not limited in embodiments of this application. In some embodiments of this application, as shown in FIG. 2, the mobile phone may be a curved-screen mobile phone. The display module of the curved-screen mobile phone includes a curved screen 10a. The curved screen 10a is disposed opposite to the battery cover 12, and an edge of the curved screen 10a is bent in a direction of approaching the battery cover 12. The curved screen 10a includes a planar part 101 and a curved part 102 connected to the planar part 101. It may be understood that the planar part 101 is a part that is of the curved screen 10a and that is parallel to the X-Y plane, and the curved part 102 is a bent part of the curved screen 10a.

In some embodiments, as shown in FIG. 2, the curved screen 10a is a double-curved display panel. The curved screen 10a includes one planar part 101 and two curved parts 102, and the two curved parts 102 are disposed on two sides of the planar part 101 in an X direction.

In some other embodiments, the curved screen 10a is a quad-curved display panel. The curved screen 10a includes one planar part 101 and four curved parts 102. Two curved parts 102 are disposed on two sides of the planar part 101 in an X direction, and the other two curved parts 102 are disposed on two sides of the planar part 101 in a Y direction.

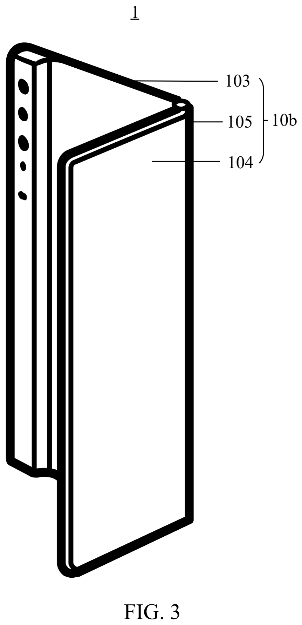

In some other embodiments, as shown in FIG. 3, the mobile phone may alternatively be a foldable-screen mobile phone. The display module of the foldable-screen mobile phone includes a flexible display panel 10b. The flexible display panel 10b includes a first non-bending region 103, a second non-bending region 104, and a bending region 105 located between the first non-bending region 103 and the second non-bending region 104.

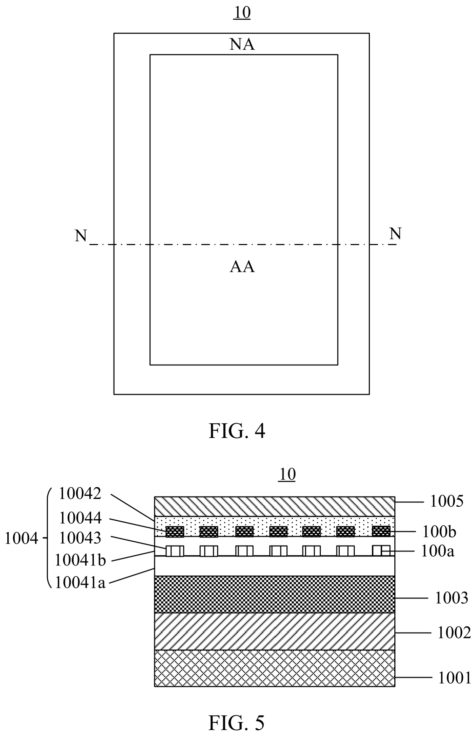

FIG. 4 is a diagram of a structure of a display module according to an embodiment of this application. As shown in FIG. 4, a display module 10 includes an active area AA (active area) and a non-active area NA (non-active area). The active area AA is disposed corresponding to a picture display region of the display module 10, and is used to display an image. The non-active area NA is used to dispose functional modules such as a display drive control module and a touch drive control module. The display module 10 may be used in an electronic device like an electronic apparatus that can perform a display and touch function, for example, the foregoing mobile phone or a tablet computer.

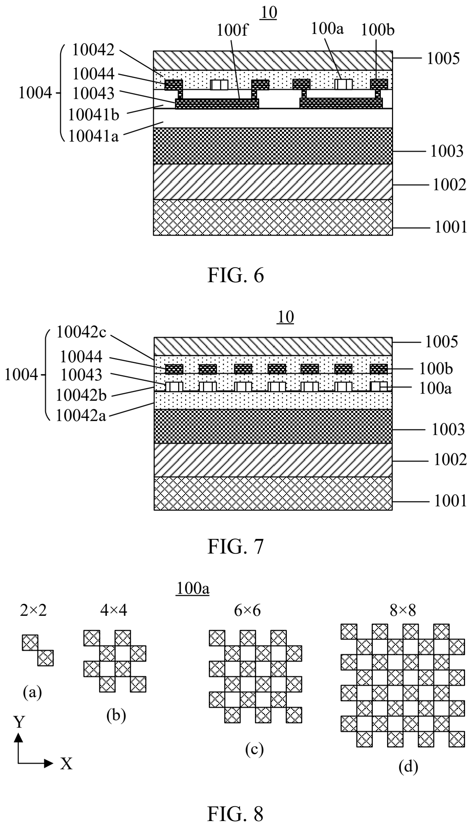

FIG. 5 is a sectional view of the display module in FIG. 4 along NN. FIG. 6 is another sectional view of the display module in FIG. 4 along NN. As shown in FIG. 5 and FIG. 6, the display module 10 includes a backplane (Backplane, BP) 1001, a display panel 1002, a thin film encapsulation (Thin Film Encapsulation, TFE) layer 1003, a touch on encapsulation (Touch on Encapsulation, TOE) layer 1004, and a color filter on encapsulation (Color filter on Encapsulation, COE) 1005 that are stacked in a Z direction.

In this embodiment, the display panel 1002 is an organic light-emitting display material (Organic Light-Emitting Diode, OLED). Pixel regions arranged in a matrix are disposed on the backplane 1001. Each pixel region is provided with a drive circuit and a drive electrode that are configured to drive the display panel 1002 to emit light. The thin film encapsulation layer 1003 is configured to encapsulate the display panel 1002. The drive circuit cooperates with the drive electrode to drive the material of the display panel 1002 to emit light to perform image display.

In some embodiments, the display panel 1002 may be an active-matrix organic light-emitting diode (active-matrix organic light-emitting diode, AMOLED) display panel.

As a self-luminous display panel, the AMOLED display panel does not need to be provided with a backlight module (backlight module, BLM). When a substrate of the AMOLED display panel is made of a flexible resin material, for example, polyethylene terephthalate (polyethylene terephthalate, PET), the AMOLED display panel 1002 can have a bendable characteristic.

In this embodiment, the thin film encapsulation layer 1003 includes two opposite surfaces: a first surface and a second surface. The first surface is close to the display panel 1002, the second surface is away from the display panel 1002, and the touch on encapsulation layer 1004 is disposed on the second surface. The touch on encapsulation layer 1004 includes an encapsulation layer and a touch detection layer. The touch detection layer is configured to identify a position of a touch applied to the display module 10, and the encapsulation layer is configured to protect structures such as the touch detection layer and the thin film encapsulation layer 1003. A manner in which the touch detection layer is disposed on a surface of the thin film encapsulation layer 1003 is touch on encapsulation.

In some embodiments, the touch detection layer includes a first metal layer 10043 and a second metal layer 10044. The encapsulation layer is made of an inorganic material and an organic material. The inorganic material includes silicon nitride (SINx), silicon oxide, or silicon oxynitride. The organic material includes an organic coating (Organic Coating, OC).

In this embodiment, the encapsulation layer includes a first inorganic material layer 10041a, a second inorganic material layer 10041b, and an organic layer 10042 that are stacked. The first metal layer 10043 is disposed on a surface that is of the first inorganic material layer 10041a and that is close to the second inorganic material layer 10041b, the second inorganic material layer 10041b covers the first metal layer 10043, the second metal layer 10044 is disposed on a surface that is of the second inorganic material layer 10041b and that is close to the organic layer 10042, and the organic layer 10042 covers the second metal layer 10044.

In some embodiments, as shown in FIG. 5, the first metal layer 10043 includes a plurality of first electrodes 100a, and the second metal layer 10044 includes a plurality of second electrodes 100b.

In some other embodiments, as shown in FIG. 6, the second metal layer 10044 includes a plurality of first electrodes 100a, a plurality of second electrodes 100b, and a connection channel (not shown in the figure). The plurality of first electrodes 100a are connected through the connection channel. The first metal layer 10043 includes a plurality of metal bridges 100f, and the plurality of second electrodes 100b are connected through the plurality of metal bridges 100f.

In some embodiments, the first electrode 100a is a touch driving electrode TX, and the second electrode 100b is a touch sensing electrode RX; or the first electrode 100a is a touch sensing electrode RX, and the second electrode 100b is a touch driving electrode TX.

In this embodiment, the plurality of touch driving electrodes TX are configured to receive a touch driving signal provided by a touch control module. The plurality of touch driving electrodes TX generate an induction capacitance with the plurality of touch sensing electrodes RX based on the touch driving signal. The plurality of touch sensing electrodes RX may correspondingly output a corresponding electrical signal as a touch sensing signal. When the capacitance between the touch driving electrodes TX and the touch sensing electrodes RX changes due to a touch operation of a user, the touch sensing signal output by the touch sensing electrodes RX accordingly changes. A specific position of the touch operation may be identified by analyzing a specific position at which the sensing signal changes.

However, in the foregoing embodiments, the inorganic material has poor bending resistance performance. When the inorganic material is used for the curved screen 10a or the flexible display panel 10b, a black spot or a black screen is easily generated due to an encapsulation failure of the display panel.

Therefore, embodiments of this application provide an improved display module. At an upper touch integration layer of the display module, an organic material is used to replace the inorganic material in the touch on encapsulation layer 1004 in the foregoing embodiments, to fully use a deformation capability of the organic material, and reduce a break risk of the display module in a large strain or deformation process.

FIG. 7 is a sectional view of a display module according to an embodiment of this application. As shown in FIG. 7, the display module includes a backplane 1001, a display panel 1002, an encapsulation layer, and a touch on encapsulation layer 1004 that are stacked in a z direction. In cooperation with the backplane 1001 and the encapsulation layer, the display panel 1002 emits light to display an image.

The organic touch on encapsulation layer 1004 includes an organic layer (10042a, 10042b, and 10042c), a first metal layer 10043, and a second metal layer 10044. The first metal layer 10043 and the second metal layer 10044 are stacked in a direction away from the display panel, and both the first metal layer 10043 and the second metal layer 10044 are located in the organic layer.

In some embodiments, the organic layer uses an organic coating (Organic Coating, OC). For example, a material of the organic layer includes an organic material like silicone resin and epoxy resin.

In some embodiments, the organic layer includes a first organic layer 10042b and a second organic layer 10042c. The first organic layer 10042b is disposed on the display panel 1002, the second organic layer 10042c is disposed on the first organic layer 10042b, the first metal layer 10043 is disposed in the first organic layer 10042b, and the second metal layer 10044 is disposed in the second organic layer 10042c.

In some embodiments, the organic layer further includes a third organic layer 10042a, and the third organic layer 10042a is disposed between the display panel 1002 and the first organic layer 10042b.

The following describes a structure of the encapsulation layer with reference to FIG. 7. As shown in FIG. 7, the encapsulation layer includes the third organic layer 10042a, the first organic layer 10042b, and the second organic layer 10042c that are stacked. The first metal layer 10043 is disposed on a surface that is of the third organic layer 10042a and that is close to the first organic layer 10042b, the first organic layer 10042b covers the first metal layer 10043, the second metal layer 10044 is disposed on a surface that is of the first organic layer 10042b and that is close to the second organic layer 10042c, and the second organic layer 10042c covers the second metal layer 10044.

Therefore, in the display module provided in this embodiment of this application, the encapsulation layer at the touch on encapsulation layer 1004 is made of the organic material. In comparison with the solution shown in FIG. 4, the display module has a better deformation capability, and a break risk of the display module in a large strain or deformation process is reduced.

In some embodiments of this application, the first metal layer 10043 includes first electrodes 100a, the second metal layer 10044 includes second electrodes 100b, and the first electrodes and the second electrodes are configured to output a first signal when a touch operation is detected.

In this way, the first electrodes 100a and the second electrodes 100b are disposed at different layers. In comparison with disposing the first electrodes 100a and the second electrodes 100b at a same layer, there is no need to use a design with a large quantity of micro vias for bridging in the organic layer, to avoid a via residue caused by insufficient resolution of the organic material, so as to reduce a risk of signal disconnection caused by the via residue, and improve a product yield rate.

A quantity of first electrodes 100a and a quantity of second electrodes 100b are not limited in embodiments of this application. There may be a plurality of first electrodes 100a, and there may be a plurality of second electrodes 100b. The plurality of first electrodes 100a and the plurality of second electrodes 100b may be arranged in an array.

In some embodiments, a minimum unit (a shape of a single electrode) of the first electrodes 100a and the second electrodes 100b is in a diamond shape, and signal strength at an end point of the diamond is greater than signal strength at an edge of the diamond. Consequently, linearity effect of a stylus is poor.

To further improve touch performance of the display module, an arrangement manner of the first electrodes 100a and the second electrodes 100b may be adjusted, to improve linearity effect of an active stylus.

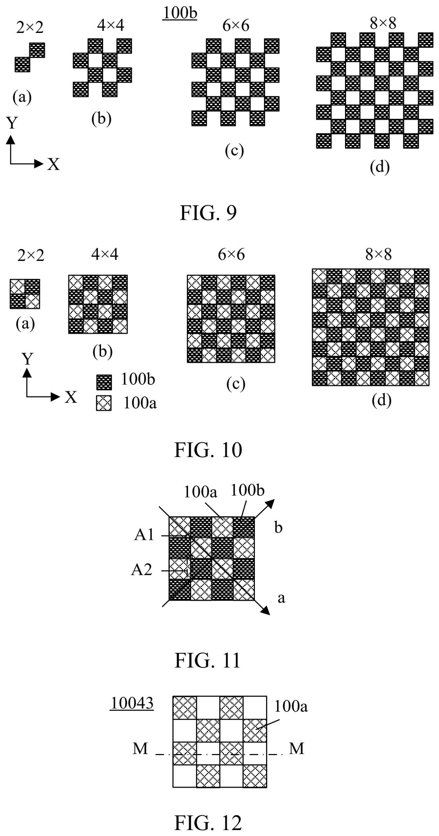

In some embodiments of this application, as shown in (a), (b), (c), and (d) in FIG. 10, projections of the first electrodes 100a on the second metal layer 10044 and the second electrodes 100b are alternately arranged in a first direction and a second direction respectively, and the first direction is perpendicular to the second direction.

In some embodiments, as shown in FIG. 10, the first direction may be an X direction, and the second direction may be a Y direction; or the first direction may be a Y direction, and the second direction may be an X direction.

In this way, the projections of the first electrodes 100a on the second metal layer 10044 and the second electrodes 100b may be mutually nested, and an arrangement is in a checkerboard manner, to reduce a drive load of the touch control module.

In some embodiments of this application, sizes of the first electrode 100a in the first direction and the second direction remain unchanged, and sizes of the second electrode 100b in the first direction and the second direction remain unchanged. For example, both the first electrode 100a and the second electrode 100b use a square pattern, so that the sizes of the first electrode 100a in the X direction and the Y direction remain unchanged, and the sizes of the second electrode 100b in the X direction and the Y direction remain unchanged.

In this way, sizes of a single electrode in the first direction and the second direction remain unchanged, so that when the stylus slides over a screen, signal strength at all positions are even, performance of the active stylus is better, and the linearity effect is better.

With reference to FIG. 8, FIG. 9, and FIG. 10, the following describes arrangement manners of the plurality of first electrodes 100a in the first metal layer 10043 and the plurality of second electrodes 100b in the second metal layer 10044.

FIG. 8 is a diagram of an arrangement manner of the first electrodes. In some embodiments, the first metal layer 10043 may include a plurality of 2×2 repetition units (units) shown in (a) in FIG. 8. The repetition unit includes two first electrodes 100a that are spaced from each other in the X direction and the Y direction respectively, and sizes of the repetition unit in the X direction and the Y direction remain unchanged.

Alternatively, the first metal layer 10043 may include a plurality of 4×4 repetition units shown in (b) in FIG. 8. The repetition unit includes eight first electrodes 100a that are spaced from each other in the X direction and the Y direction respectively, and sizes of the repetition unit in the X direction and the Y direction remain unchanged.

Alternatively, the first metal layer 10043 includes a plurality of 6×6 repetition units shown in (c) in FIG. 8. The repetition unit includes 18 first electrodes 100a that are spaced from each other in the X direction and the Y direction respectively, and sizes of the repetition unit in the X direction and the Y direction remain unchanged.

Alternatively, the first metal layer 10043 includes a plurality of 8×8 repetition units shown in (d) in FIG. 8. The repetition unit includes 32 first electrodes 100a that are spaced from each other in the X direction and the Y direction respectively, and sizes of the repetition unit in the X direction and the Y direction remain unchanged.

FIG. 9 is a diagram of an arrangement manner of the second electrodes. In some embodiments, the second metal layer 10044 may include a plurality of 2×2 repetition units shown in (a) in FIG. 9. The repetition unit includes two second electrodes 100b that are spaced from each other in the X direction and the Y direction respectively, and sizes of the repetition unit in the X direction and the Y direction remain unchanged.

Alternatively, a plurality of 4×4 repetition units shown in (b) in FIG. 9 are included. The repetition unit includes eight second electrodes 100b that are spaced from each other in the X direction and the Y direction respectively, and sizes of the repetition unit in the X direction and the Y direction remain unchanged.

Alternatively, a plurality of 6×6 repetition units shown in (c) in FIG. 9 are included. The repetition unit includes 18 second electrodes 100b that are spaced from each other in the X direction and the Y direction respectively, and sizes of the repetition unit in the X direction and the Y direction remain unchanged.

Alternatively, a plurality of 8×8 repetition units shown in (d) in FIG. 9 are included. The repetition unit includes 32 second electrodes 100b. Sizes of the repetition unit in the X direction and the Y direction remain unchanged. The repetition units are spaced from each other in the X direction and the Y direction respectively, and sizes of the repetition unit in the X direction and the Y direction remain unchanged.

FIG. 10 is a diagram of an arrangement manner of the first metal layer 10043 and the second metal layer 10044. In some embodiments, as shown in (a), (b), (c), and (d) in FIG. 10, a plurality of repetition units of the first metal layer 10043 and the second metal layer 10044 are mutually nested in a vertical direction, to present checkerboard distribution.

A size of a side length of a single checkerboard is 3 mm to 5 mm.

Therefore, in the display touch module provided in this embodiment of this application, the projections of the first electrodes 100a on the second metal layer and the second electrodes 100b are mutually nested, to present a checkerboard arrangement. In addition, the sizes of the single electrode in the first direction and the second direction remain unchanged, so that when the stylus slides over the screen, the signal strength at all the positions are even, the performance of the active stylus is better, and the linearity effect is better.

Structures of the first electrode 100a and the second electrode 100b are not limited in embodiments of this application. In some embodiments of this application, as shown in FIG. 8 and FIG. 10, the first electrode 100a includes a plurality of first sub-metal conducting wires, and the plurality of first sub-metal conducting wires form a plurality of metal grids. As shown in FIG. 9 and FIG. 10, the second electrode 100b includes a plurality of second sub-metal conducting wires, and the plurality of second sub-metal conducting wires form a plurality of metal grids.

In some embodiments, a shape of the metal grid may be a square, a rectangle, a diamond, or a shape of another type of polygon. The metal grids of the first electrode 100a and the second electrode 100b may be in a same shape. For ease of differentiation, the first electrode 100a and the second electrode 100b in FIG. 8, FIG. 9, and FIG. 10 are separately illustrated by using grids of different shapes. This is for reference only, and a grid shape is not limited.

In some embodiments of this application, the display panel includes a plurality of pixel regions arranged in a matrix. Each metal grid is directly opposite to one pixel unit, and a shape of the metal grid is the same as a shape of the pixel unit.

As shown in FIG. 11, the plurality of first electrodes 100a extend in a third direction a, the plurality of second electrodes 100b extend in a fourth direction b, and the third direction a is perpendicular to the fourth direction b. In some embodiments, an overlapping width of a cross position A1 of the first electrode 100a and the second electrode 100b is greater than or equal to a line width of the metal grid, and an overlapping width of a non-cross position A2 of the first electrode 100a and the second electrode 100b is less than the line width of the metal grid.

In some embodiments, the line width of the metal grid is 3 µm to 6 µm. In this way, the line width of the metal grid is at a micron level, and the overlapping width of the first electrode and the second electrode is reduced, so that induction capacitance of the first sub-metal conducting wires and the second sub-metal conducting wires in a vertical stacking direction can be effectively reduced, to further reduce the drive load of the touch control module.

In the foregoing embodiments, as shown in FIG. 12, the first metal layer 10043 includes the plurality of first electrodes 100a, and the plurality of first electrodes 100a are spaced from each other. There is a gap between the plurality of first electrodes 100a, and the gap corresponds to the second electrode.

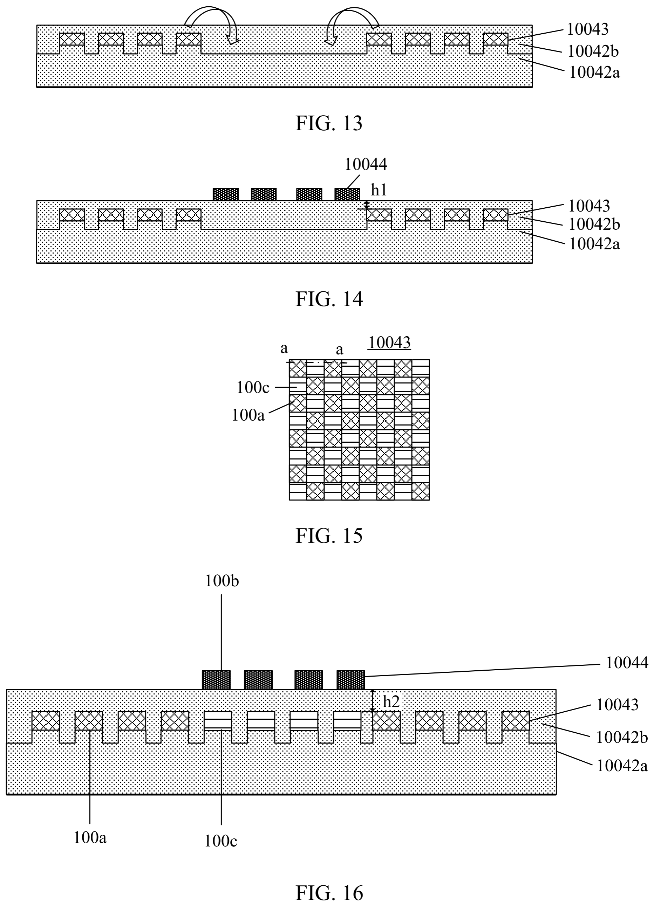

FIG. 13 is a sectional view of the first metal layer in FIG. 12 along MM. As shown in FIG. 13, the first metal layer 10043 is located on a surface of the third organic layer 10042a. When the first metal layer 10043 is prepared, to fully etch the first metal layer 10043 at a gap position, a specific overetching amount is increased. In this case, due to existence of overetching, the third organic layer 10042a is overetched to a specific depth, and the third organic layer 10042a has a large-area overetched region at a position without the first electrode 100a. The first organic layer 10042b covers the first metal layer 10043. Due to existence of the large-area overetched region of the third organic layer 10042a, the first organic layer 10042b above the first metal layer 10043 extensively flows, in a direction shown by an arrow in FIG. 13, to a region in which the gap is located. Therefore, the first organic layer 10042b between the first metal layer 10043 and the second metal layer 10044 is slightly thin, as shown in FIG. 14. Consequently, there is a risk of a short circuit between the first metal layer 10043 and the second metal layer 10044.

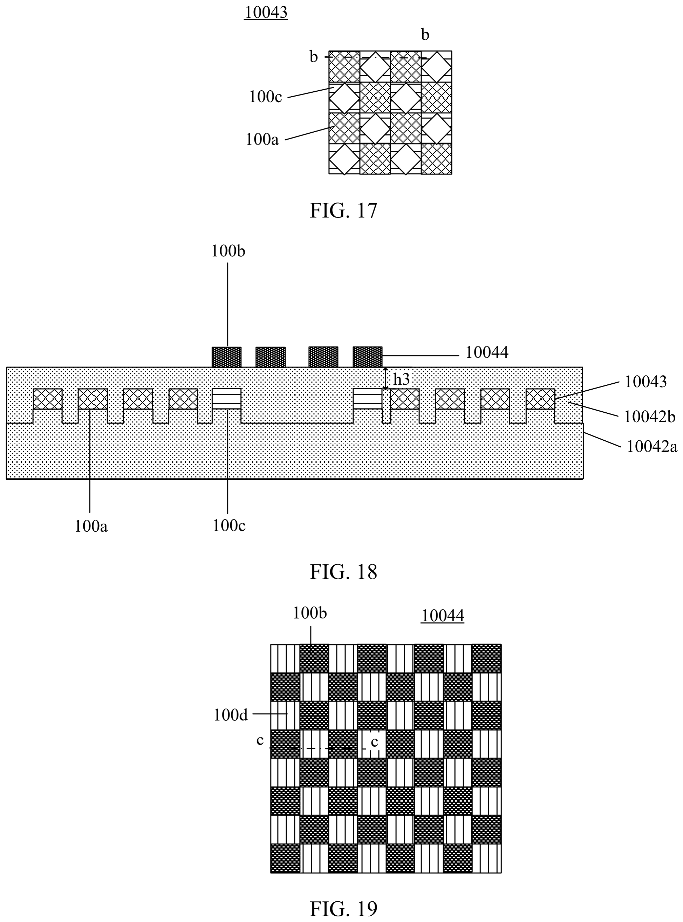

To reduce the risk of the short circuit between the first metal layer 10043 and the second metal layer 10044, in some embodiments, a first floating metal grid 100c may be disposed in a region other than the first electrodes 100a on the first metal layer 10043. For example, as shown in FIG. 15 and FIG. 17, the first metal layer 10043 further includes a plurality of first floating metal grids 100c, the first floating metal grids 100c are disposed between adjacent first electrodes 100a and spaced from each other, and the first floating metal grids 100c are insulated from the first electrodes 100a. The first floating metal grid 100c is in a floating vacant state.

In some embodiments, as shown in FIG. 15, disposing the first floating metal grids 100c in the region other than the first electrodes 100a on the first metal layer 10043 may be disposing the first floating metal grids 100c in the entire region other than the first electrodes 100a on the first metal layer 10043. Projections of the plurality of first floating metal grids 100c on the second metal layer 10044 coincide with the second metal grids.

In this embodiment, the first floating metal grid 100c may be in a shape of a diamond, a rectangle, a square, or the like. The first floating metal grid 100c and the grid of the first electrode 100a may use a same structure. For ease of differentiation, the first floating metal grid 100c and the metal grid of the first electrode 100a in FIG. 15 are separately illustrated in different shapes. This is for reference only, and a grid shape is not limited.

In some embodiments, the first floating metal grid 100c in the first metal layer 10043 may be obtained by cutting and separating a conductive pattern of the first electrode 100a.

FIG. 16 is a sectional view of FIG. 15 along aa. As shown in FIG. 16, existence of the first floating metal grids 100c in the first metal layer 10043 reduces the large-area overetched region of the third organic layer 10042a, and reduces flow of the first organic layer 10042b. In this case, a thickness h2 of the first organic layer 10042b between the first metal layer 10043 and the second metal layer 10044 is greater than a thickness h1 in FIG. 14. This can effectively reduce a risk of a short circuit (a micro short circuit) between touch metal layers, namely, the first metal layer 10043 and the second metal layer 10044, due to thickness insufficiency of the first organic layer 10042b.

In some other embodiments, disposing the first floating metal grids 100c in the region other than the first electrodes 100a on the first metal layer 10043 may be disposing the first floating metal grids 100c in a part of the region other than the first electrodes 100a on the first metal layer 10043. As shown in FIG. 17, projections of the plurality of first floating metal grids 100c on the second metal layer 10044 partially coincide with the second metal grids.

In this embodiment, the first floating metal grids 100c are added to some positions in the region other than the first electrode 100a on the first metal layer 10043. An area of the first floating metal grid 100c may be adjusted based on an actual requirement. This is not limited herein, provided that the area of the first floating metal grid 100c is greater than 0 and less than an area of the first floating metal grid 100c shown in FIG. 15.

FIG. 18 is a sectional view of FIG. 17 along bb. As shown in FIG. 18, existence of the first floating metal grids 100c in the first metal layer 10043 eliminates the large-area overetched region of the third organic layer 10042a. Because extensive flow of the first organic layer 10042b is avoided, a thickness h3 of the first organic layer 10042b between the first metal layer 10043 and the second metal layer 10044 is greater than a thickness h1 in FIG. 14. This can effectively reduce a risk of a short circuit (a micro short circuit) between touch metal layers, namely, the first metal layer 10043 and the second metal layer 10044, due to thickness insufficiency of the first organic layer 10042b.

In addition, in comparison with FIG. 16, an overlapping area between the first metal layer 10043 and the second metal layer 10044 in FIG. 18 is reduced, so that a load of the first metal layer 10043 and a load of the second metal layer 10044 are lower, and touch performance is better. In addition, the area of the first floating metal grid 100c is smaller, further reducing a risk of a short circuit between the second electrodes 100b and the first floating metal grids 100c.

In the foregoing embodiments, the first floating metal grids 100c are disposed in the region other than the first electrodes 100a on the first metal layer 10043, to reduce the risk of the short circuit between the touch metal layers, namely, the first metal layer 10043 and the second metal layer 10044, due to loss of the first organic layer 10042b. In some other embodiments, to further reduce the risk of the short circuit, the second metal layer 10044 may be further improved.

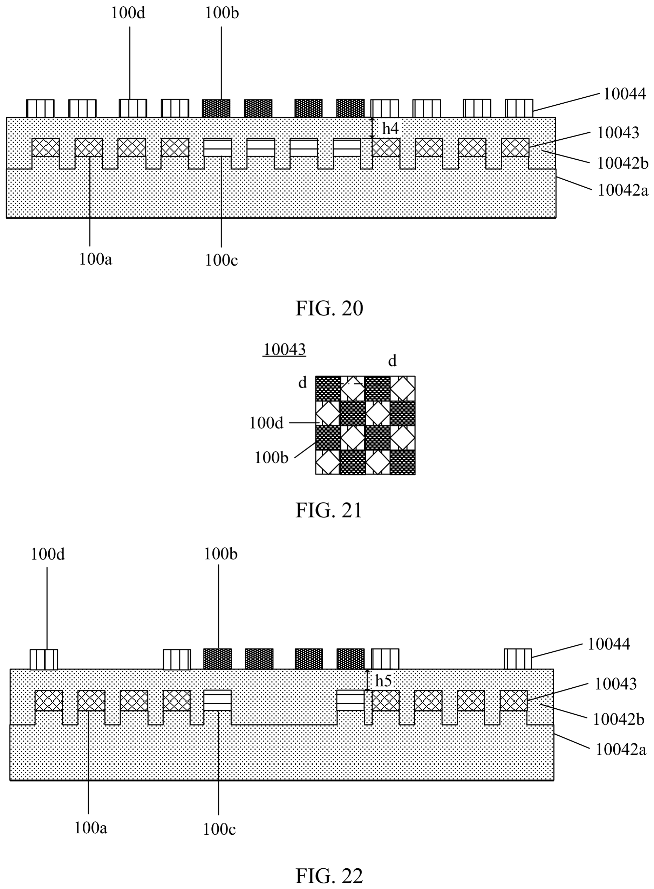

The second metal layer 10044 further includes a plurality of second floating metal grids 100d, and the second floating metal grids 100d may be disposed in a region other than the second electrodes 100b on the second metal layer 10044. As shown in FIG. 19 and FIG. 21, the second floating metal grids 100d are disposed between adjacent second electrodes 100b and spaced from each other, and the floating metal grids are insulated from the second electrodes 100b.

In some embodiments, as shown in FIG. 19, disposing the second floating metal grids 100d in the region other than the second electrodes 100b on the second metal layer 10044 may be disposing the second floating metal grids 100d in the entire region other than the second electrodes 100b on the second metal layer 10044. Projections of the plurality of second floating metal grids 100d on the first metal layer 10043 coincide with the first metal grids.

In this embodiment, the second floating metal grid 100d may be in a shape of a diamond, a rectangle, a square, or the like. The second floating metal grid 100d and the grid of the first electrode 100a may use a same structure. For ease of differentiation, the second floating metal grid 100d and the metal grid of the second electrode 100b in FIG. 19 are separately illustrated in different shapes. This is for reference only, and a grid shape is not limited.

In some embodiments, the second floating metal grid 100d in the second metal layer 10044 may be obtained by cutting and separating a conductive pattern of the second electrode 100b.

In some examples of this embodiment, the first floating metal grids 100c may be disposed in a part of the region other than the first electrodes 100a on the first metal layer 10043 (not shown in the figure). In some other examples of this embodiment, as shown in FIG. 20, the first floating metal grids 100c may be disposed in the entire region other than the first electrodes 100a on the first metal layer 10043. These all fall within the protection scope of this application.

FIG. 20 is a sectional view of FIG. 19 along cc. As shown in FIG. 20, existence of the first floating metal grids 100c in the first metal layer 10043 reduces the large-area overetched region of the third organic layer 10042a, and reduces flow of the first organic layer 10042b. In this case, a thickness h4 of the first organic layer 10042b between the first metal layer 10043 and the second metal layer 10044 is greater than the thickness h1 in FIG. 14. This can effectively reduce a risk of a short circuit (a micro short circuit) between the first metal layer 10043 and the second metal layer 10044 due to thickness insufficiency of the second metal layer 10044. In addition, the second floating metal grid 100d in the second metal layer 10044 further improves flatness of an upper part of the second metal layer 10044.

In the foregoing embodiments, as shown in FIG. 19, the projections of the plurality of second floating metal grids 100d on the first metal layer 10043 all coincide with the first metal grids. In some other embodiments, disposing the second floating metal grids 100d in the region other than the second electrodes 100b on the second metal layer 10044 may be disposing the second floating metal grids 100d in a part of the region other than the second electrodes 100b on the second metal layer 10044. As shown in FIG. 21, the projections of the plurality of second floating metal grids 100d on the first metal layer 10043 partially coincide with the first metal grids.

As shown in FIG. 21, in addition to the first floating metal grids 100c added to some positions of the first metal layer 10043, the second floating metal grids 100d are also added to some positions of the second metal layer 10044. An area of the first floating metal grid 100c and an area of the second floating metal grid 100d may be freely selected based on an actual requirement, provided that the area of the first floating metal grid 100c is greater than 0 and less than the area of the first floating metal grid 100c shown in FIG. 15, and the area of the second floating metal grid 100d is greater than 0 and less than the area of the second floating metal grid 100d shown in FIG. 19.

In this embodiment, the second floating metal grids 100d are disposed in a part of the region other than the second electrodes 100b on the second metal layer 10044. In some examples of this embodiment, as shown in FIG. 22, the first floating metal grids 100c may be disposed in a part of the region other than the first electrodes 100a on the first metal layer 10043. In some other examples of this embodiment, the first floating metal grids 100c may be disposed in the entire region other than the first electrodes 100a on the first metal layer 10043. This is not shown in the figure. These all fall within the protection scope of this application.

FIG. 22 is a sectional view of FIG. 21 along dd. As shown in FIG. 22, existence of the first floating metal grids 100c in the first metal layer 10043 eliminates the large-area overetched region of the third organic layer 10042a. Because extensive flow of the first organic layer 10042b is avoided, a thickness h5 of the first organic layer 10042b between the first metal layer 10043 and the second metal layer 10044 is greater than the thickness h1 of the first organic layer 10042b in FIG. 14. This can effectively reduce a risk of a short circuit (a micro short circuit) between touch metal layers, namely, the first metal layer 10043 and the second metal layer 10044, due to thickness insufficiency of the first organic layer 10042b.

In comparison with FIG. 20, an overlapping area between the first metal layer 10043 and the second metal layer 10044 in FIG. 22 is smaller, so that a load of the first metal layer 10043 and a load of the second metal layer 10044 are lower, and touch performance is better. In addition, areas of the first floating metal grid 100c and the second floating metal grid 100d are smaller, to further reduce a risk of a short circuit between the second electrodes 100b and the first floating metal grids 100c and a risk of a short circuit between the first electrodes 100a and the second floating metal grids 100d.

In the foregoing embodiments, a structure of a touch integration layer of the display touch module is improved, to improve touch performance. In some other embodiments, the display touch module further includes a touch metal trace, and the touch metal trace is disposed in an organic machine layer, easily causing an etching residue.

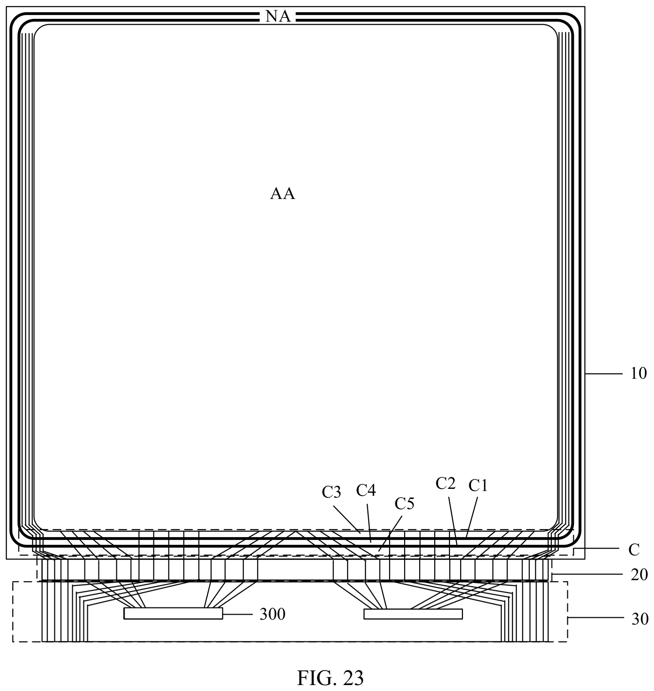

Therefore, an embodiment of this application further provides a display touch module, to reduce an etching residue of a touch metal trace. As shown in FIG. 23, the display touch module includes a display module 10, a bent part 20, and a lower bonding region 30. One end of the display module 10 is connected to the lower bonding region 30 through the bent part 20, and the lower bonding region 30 is bent to a back side of a light outlet surface of the display module 10 through the bent part 20.

In some embodiments, the lower bonding region includes a system on chip (System on Chip, SoC) 300, which may be bound in the lower bonding region 30. Bonding (bonding) is a wire bonding manner in a manufacturing and packaging process of a microelectronic device. For example, a metal wire (a gold wire or the like) may be used to complete connection between internal interconnection lines of a solid-state circuit in the microelectronic device by using thermal pressure or ultrasonic energy. The process may include pressure welding, wire bonding, bonding, ball bonding, flat position welding, and the like. For example, the system on chip 300 is bound in the lower bonding region 30.

In some embodiments, the display module 10 includes a display panel, an organic layer, a first metal layer 10043, and a second metal layer 10044. The first metal layer 10043 and the second metal layer 10044 are stacked in a direction away from the display panel, and both the first metal layer 10043 and the second metal layer 10044 are located in the organic layer.

In some embodiments, the display module 10 includes an active area AA, a non-active area NA, and an organic clearance region (C3, C4, and C5) and a dam (C1 and C2) that are located in the non-active area NA. The organic clearance region (C3, C4, and C5) and the dam (C1 and C2) are spaced from each other, and both the organic clearance region (C3, C4, and C5) and the dam (C1 and C2) are disposed around the active area AA. The first metal layer 10043 and the second metal layer 10044 need to cross above the dam (C1 and C2) and the organic clearance region (C3, C4, and C5) in a region C in which the non-active area NA is adjacent to the bent part 20, to be connected to the lower bonding region 30.

In some embodiments, the organic clearance region (C3, C4, and C5) includes a first organic clearance region C3, a second organic clearance region C4, and a third organic clearance region C5 that are sequentially disposed in a direction of approaching the bent part 20, and the dam (C1 and C2) includes a first dam C1 and a second dam C2. The first dam C1 is located between the first organic clearance region C3 and the second organic clearance region C4, and the second dam C2 is located between the second organic clearance region C4 and the third organic clearance region C5.

In some embodiments, a height of the second barrier C2 is higher than a height of the first barrier C1, so that the organic layer can be better limited in a region of the display panel.

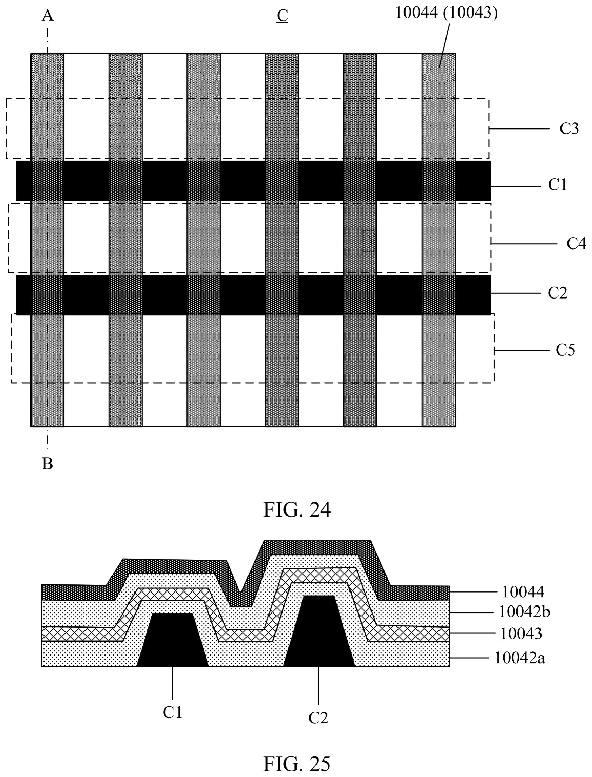

In some embodiments, as shown in FIG. 24 and FIG. 25, a double-layer metal design of the first metal layer 10043 and the second metal layer 10044 is used for the touch metal trace above the dam (C1 and C2) and the organic clearance region (C3, C4, and C5) in the region C in which the non-active area NA is adjacent to the bent part 20. There is a height difference caused by the organic clearance region (C3, C4, and C5) of the backplane 1001 near the first dam C1 and the second dam C2, and the third organic layer 10042a and the first organic layer 10042b are stacked in the organic clearance region (C3, C4, and C5) of the backplane 1001. Therefore, the first metal layer 10043 and the second metal layer 10044 generate etching residues at the stacking positions of the third organic layer 10042a and the first organic layer 10042b. In addition, a thicker stacking thickness of the third organic layer 10042a and the first organic layer 10042b more easily causes the etching residues of the first metal layer 10043 and the second metal layer 10044.

In some embodiments, a single-layer trace is used for the first metal layer 10043 and the second metal layer 10044 above the dam (C1 and C2) and the organic clearance region (C3, C4, and C5) in the region C in which the non-active area NA is adjacent to the bent part 20.

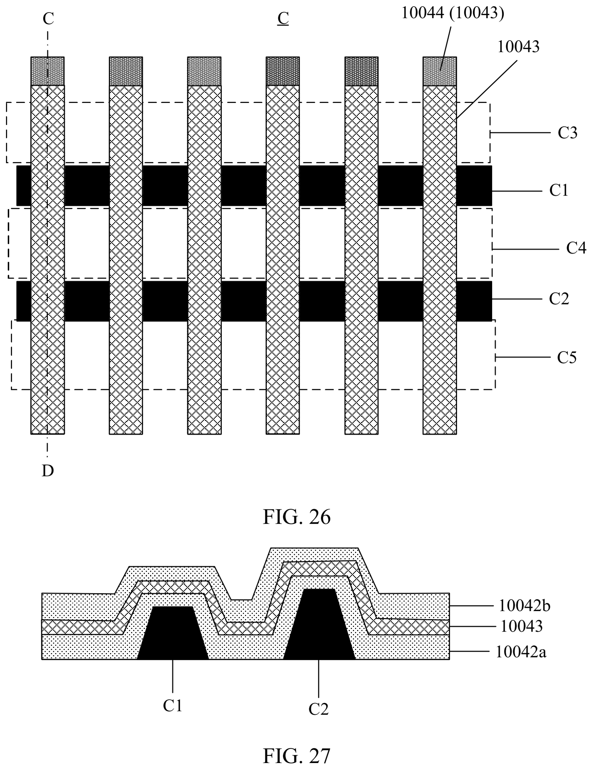

In some examples of this embodiment, as shown in FIG. 26 and FIG. 27, a touch trace above the first dam C1, the second dam C2, the first organic clearance region C3, the second organic clearance region C4, and the third organic clearance region C5 is designed by using the single-layer first metal layer 10043. Using the single-layer first metal layer 10043 as the metal trace can effectively avoid a risk of a short circuit between the touch signal lines caused by an etching residue of the second metal layer 10044.

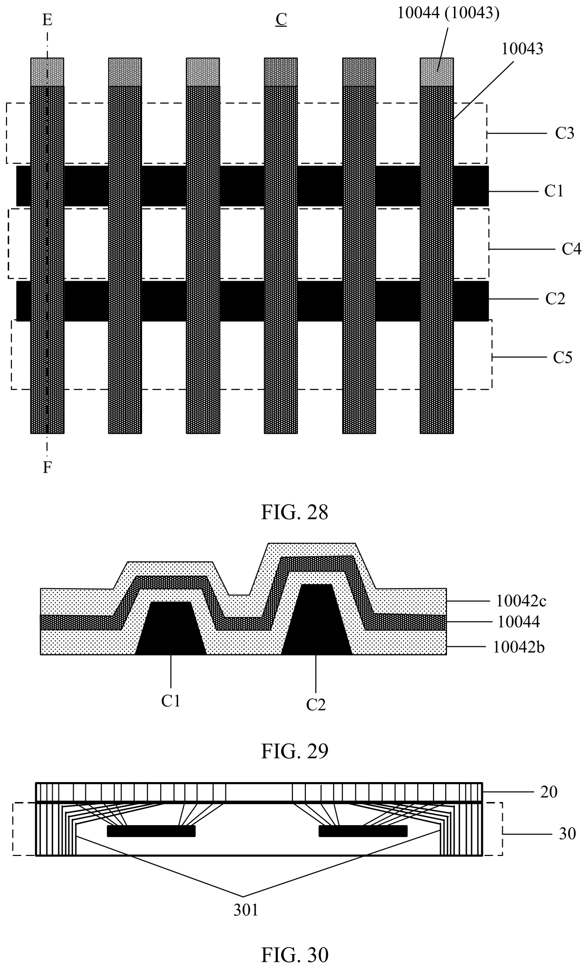

In some other examples of this embodiment, as shown in FIG. 28 and FIG. 29, a touch trace above the first dam C1, the second dam C2, the first organic clearance region C3, the second organic clearance region C4, and the third organic clearance region C5 is designed by using the single-layer second metal layer 10044 as the touch trace.

According to the display touch module provided in this embodiment, etching metal residues of the first metal layer 10043 and the second metal layer 10044 above the dam (C1 and C2) and the organic clearance region (C3, C4, and C5) in the region C in which the non-active area NA is adjacent to the bent part 20 can be reduced, to reduce the risk of the short circuit.

In some embodiments, the first metal layer 10043 and the second metal layer 10044 extend to the lower bonding region 30. In the lower bonding region, the metal trace of the touch integration layer is used for all touch signals, and the trace is dense in the lower bonding region. The metal layer easily generates a metal etching residue on the surface of the third organic layer 10042a or the first organic layer 10042b, causing a short circuit between the touch signals.

Therefore, an embodiment of this application further provides a display touch module, to further reduce an etching residue of a touch metal trace. The display touch module includes a display module 10, a bent part 20, and a lower bonding region 30. One end of the display module 10 is connected to the lower bonding region 30 through the bent part 20, and the lower bonding region 30 is bent to a back side of a light outlet surface of the display module 10 through the bent part 20.

In some embodiments, the display module 10 includes a display panel, an organic layer, a first metal layer 10043, and a second metal layer 10044. The first metal layer 10043 and the second metal layer 10044 are stacked in a direction away from the display panel, and both the first metal layer 10043 and the second metal layer 10044 are located in the organic layer.

In some embodiments, as shown in FIG. 30, the lower bonding region 30 includes a first metal trace 301, where the first metal trace 301 is electrically connected to the first metal layer 10043 and the second metal layer 10044, and a connection point between the first metal trace 301 and the first metal layer 10043 and a connection point between the first metal trace 301 and the second metal layer 10044 are located outside the lower bonding region 30. In other words, in the lower bonding region, the first metal trace 301 in the lower bonding region may be used to replace the traces of the first metal layer 10043 and the second metal layer 10044.

For example, the first metal trace 301 may be a backplane metal trace, and the first metal trace 301 may be used to replace all or a part of the trace of the first metal layer 10043 or the second metal layer 10044, to reduce a short circuit between touch signals caused by the etching residue of the touch metal trace above the organic layer in the upper touch integration technology.

In some examples of this embodiment, all touch signal traces in the lower bonding region 30 are replaced with the first metal trace 301.

In some other examples of this embodiment, a part of touch signal traces in the lower bonding region 30 are replaced with the first metal trace 301.

In the display touch module provided in this embodiment of this application, the backplane metal trace 301 is used in the lower bonding region 30 to replace the touch integrated metal trace. Materials of the touch integrated metal trace and the third organic layer 10042a or the first organic layer 10042b may be removed from the lower bonding region 30, to avoid the etching residue of the first metal layer 10043 or the second metal layer 10044 on the material of the third organic layer 10042a or the first organic layer 10042b, so as to reduce the risk of the short circuit between the touch signals.

Embodiments of this application provide a display touch module and an electronic device. The display touch module includes a display panel, a first organic layer disposed on the display panel, and a second organic layer disposed on the first organic layer. The display touch module further includes a first metal layer and a second metal layer, the first metal layer is disposed in the first organic layer, and the second metal layer is disposed in the second organic layer. In comparison with using an inorganic encapsulation layer, the display touch module has a better deformation capability, thereby reducing a break risk of the display touch module in a large strain or deformation process. The first metal layer includes first electrodes, the second metal layer includes second electrodes, and the first electrodes and the second electrodes are configured to output a first signal when a touch operation is detected. The first electrodes and the second electrodes are disposed at different layers. In comparison with disposing the first electrodes and the second electrodes at a same layer, there is no need to use a design with a large quantity of micro vias for bridging in the organic layer, to avoid a via residue caused by insufficient resolution of an organic material, so as to reduce a risk of signal disconnection caused by the via residue, and improve a product yield rate. Projections of the first electrodes on the second metal layer and the second electrodes are alternately arranged in a first direction and a second direction respectively. The first direction is perpendicular to the second direction, so that the projections of the first electrodes on the second metal layer and the second electrodes are mutually nested, and an arrangement is in a checkerboard manner, to reduce a drive load of the touch control module.

In some embodiments, this application further provides a display touch module. Compared with the foregoing display touch module, the display touch module further includes a bent part and a lower bonding region. One end of the display panel is connected to the lower bonding region through the bent part, and the lower bonding region is bent to a back side of a light outlet surface of the display panel through the bent part. The first metal layer and the second metal layer are stacked in a direction away from the display panel, and both the first metal layer and the second metal layer are located in the organic layer. The lower bonding region includes a first metal trace, the first metal trace is electrically connected to the first metal layer and the second metal layer, and a connection point between the metal trace and the first metal layer and a connection point between the metal trace and the second metal layer are located outside the lower bonding region. In other words, the first metal trace in the lower bonding region may be used to replace traces of the first metal layer and the second metal layer, and the touch integration layer does not need to be disposed in the lower bonding region, to reduce an etching residue of the first metal layer or the second metal layer on the organic layer, and reduce a risk of touch signal disconnection.

In some embodiments, this application further provides a display touch module. A display panel of the display touch module includes an active area, a non-active area, and an organic clearance region and a dam that are located in the non-active area, where the organic clearance region and the dam are spaced from each other, both the organic clearance region and the dam are disposed around the active area, and in a region in which the non-active area is adjacent to the bent part, a single-layer trace is used for the first metal layer and the second metal layer above the organic clearance region and the dam. In this way, the single-layer metal trace is disposed above the organic clearance region and the dam, to reduce etching metal residues of the first metal layer and the second metal layer above the dam and the organic clearance region in the region in which the non-active area is adjacent to the bent part, and reduce a risk of a short circuit.

In some embodiments, this application further provides a display touch module. A first metal layer in the display touch module further includes a plurality of first floating metal grids. The first floating metal grids are disposed between adjacent first electrodes and spaced from each other, and the first floating metal grids are insulated from the first electrodes. In this way, the first floating metal grid reduces a large-area overetched region of the organic layer at gap positions between the first electrodes, and reduces flow of the organic layer above the first metal layer to the gaps between the first electrodes. In this way, loss of the organic layer between the first metal layer and the second metal layer is reduced, and a risk of a short circuit between the first metal layer and the second metal layer is reduced.

The display touch modules in the foregoing aspects all fall within the protection scope of this application, and a sequence of the display touch modules is not limited.

The foregoing descriptions are merely specific implementations of this application, but are not intended to limit the protection scope of this application. Any variation or replacement within the technical scope disclosed in this application shall fall within the protection scope of this application. Therefore, the protection scope of this application shall be subject to the protection scope of the claims.

## Claims

1. A display touch module, comprising a display panel, a first organic layer disposed on the display panel, and a second organic layer disposed on the first organic layer, wherein the display touch module further comprises a first metal layer and a second metal layer, the first metal layer is disposed in the first organic layer, and the second metal layer is disposed in the second organic layer;
the first metal layer comprises first electrodes, the second metal layer comprises second electrodes, and the first electrodes and the second electrodes are configured to output a first signal when a touch operation is detected; and
projections of the first electrodes on the second metal layer and the second electrodes are alternately arranged in a first direction and a second direction respectively, and the first direction is perpendicular to the second direction.

2. The display touch module according to claim 1, wherein sizes of the first electrode in the first direction and the second direction remain unchanged, and sizes of the second electrode in the first direction and the second direction remain unchanged.

3. The display touch module according to claim 2, wherein both the first electrode and the second electrode use a square pattern.

4. The display touch module according to any one of claims 1 to 3, wherein the first electrodes extend in a third direction, the second electrodes extend in a fourth direction, and the third direction intersects with the fourth direction.

5. The display touch module according to any one of claims 1 to 4, wherein the first metal layer further comprises first floating metal grids, the first floating metal grids are disposed between adjacent first electrodes and spaced from each other, and the first floating metal grids are insulated from the first electrodes.

6. The display touch module according to claim 5, wherein the second metal layer further comprises second floating metal grids, the second floating metal grids are disposed between adjacent second electrodes and spaced from each other, and the floating metal grids are insulated from the second electrodes.

7. The display touch module according to claim 5 or 6, wherein a projection area of the first floating metal grids on the second metal layer is less than or equal to an area of the second electrodes.

8. The display touch module according to any one of claims 1 to 7, wherein the display touch module further comprises a bent part and a lower bonding region, one end of the display panel is connected to the lower bonding region through the bent part, the lower bonding region is bent to a back side of a light outlet surface of the display panel through the bent part, the lower bonding region comprises a first metal trace, the first metal trace is electrically connected to the first metal layer and the second metal layer, and a connection point between the metal trace and the first metal layer and a connection point between the metal trace and the second metal layer are located outside the lower bonding region.

9. The display touch module according to claim 8, wherein the display panel comprises an active area, a non-active area, and an organic clearance region and a dam that are located in the non-active area, wherein the organic clearance region and the dam are spaced from each other, both the organic clearance region and the dam are disposed around the active area, and in a region in which the non-active area is adjacent to the bent part, a single-layer trace is used for the first metal layer and the second metal layer above the organic clearance region and the dam.

10. The display touch module according to claim 9, wherein the organic clearance region comprises a first organic clearance region, a second organic clearance region, and a third organic clearance region that are successively disposed in a direction away from the bent part, and the dam comprises a first dam and a second dam, wherein the first dam is located between the first organic clearance region and the second organic clearance region, the second dam is located between the second organic clearance region and the third organic clearance region, and a height of the first dam is greater than a height of the second dam.

11. The display touch module according to any one of claims 1 to 10, wherein the organic layer further comprises a third organic layer, and the third organic layer is disposed between the display panel and the first organic layer.

12. The display touch module according to any one of claims 1 to 11, wherein the display touch module further comprises an encapsulation layer, and the encapsulation layer is located between the display panel and the organic layer.

13. A display touch module, comprising a display panel, a bent part, a lower bonding region, a first organic layer, a second organic layer, a first metal layer, and a second metal layer, wherein
one end of the display panel is connected to the lower bonding region through the bent part, and the lower bonding region is bent to a back side of a light outlet surface of the display panel through the bent part;
the first organic layer is disposed on the display panel, the second organic layer is disposed on the first organic layer, the first metal layer is disposed in the first organic layer, and the second metal layer is disposed in the second organic layer;
the first metal layer comprises first electrodes, the second metal layer comprises second electrodes, and the first electrodes and the second electrodes are configured to output a first signal when a touch operation is detected; and
the lower bonding region comprises a first metal trace, the first metal trace is electrically connected to the first metal layer and the second metal layer, and a connection point between the metal trace and the first metal layer and a connection point between the metal trace and the second metal layer are located outside the lower bonding region.

14. A display touch module, comprising a display panel, a bent part, a lower bonding region, a first organic layer, a second organic layer, a first metal layer, and a second metal layer, wherein
one end of the display panel is connected to the lower bonding region through the bent part, and the lower bonding region is bent to a back side of a light outlet surface of the display panel through the bent part;
the first organic layer is disposed on the display panel, the second organic layer is disposed on the first organic layer, the first metal layer is disposed in the first organic layer, and the second metal layer is disposed in the second organic layer;
the first metal layer comprises first electrodes, the second metal layer comprises second electrodes, and the first electrodes and the second electrodes are configured to output a first signal when a touch operation is detected; and
the display panel comprises an active area, a non-active area, and an organic clearance region and a dam that are located in the non-active area, wherein the organic clearance region and the dam are spaced from each other, both the organic clearance region and the dam are disposed around the active area, and in a region in which the non-active area is adjacent to the bent part, a single-layer trace is used for the first metal layer and the second metal layer above the organic clearance region and the dam.

15. The display touch module according to claim 14, wherein the organic clearance region comprises a first organic clearance region, a second organic clearance region, and a third organic clearance region that are successively disposed in a direction away from the bent part, and the dam comprises a first dam and a second dam, wherein the first dam is located between the first organic clearance region and the second organic clearance region, the second dam is located between the second organic clearance region and the third organic clearance region, and a height of the first dam is greater than a height of the second dam.

16. A display touch module, comprising a display panel, a first organic layer disposed on the display panel, and a second organic layer disposed on the first organic layer, wherein the display touch module further comprises a first metal layer and a second metal layer, the first metal layer is disposed in the first organic layer, and the second metal layer is disposed in the second organic layer;
the first metal layer comprises first electrodes, the second metal layer comprises second electrodes, and the first electrodes and the second electrodes are configured to output a first signal when a touch operation is detected; and
the first metal layer further comprises first floating metal grids, the first floating metal grids are disposed between adjacent first electrodes and spaced from each other, and the first floating metal grids are insulated from the first electrodes.

17. The display touch module according to claim 16, wherein the second metal layer comprises second floating metal grids, the second floating metal grids are disposed between adjacent second electrodes and spaced from each other, and the second floating metal grids are insulated from the second electrodes.

18. The display touch module according to claim 17, wherein a projection area of the first floating metal grids on the second metal layer is less than or equal to an area of the second electrodes.

19. An electronic device, wherein the electronic device comprises a touch control module and the display touch module according to any one of claims 1 to 18, wherein the touch control module is configured to identify, based on the received first signal, a position of the touch operation received by the display touch module.
